# EUROPEAN PATENT APPLICATION

(11) **EP 4 718 981 A1**
(43) Date of publication of application: **01.04.2026**
(21) Application number: 25205113.1
(22) Date of filing: 26.09.2025
(51) Int. Cl.: H10D 30/01, H10D 30/66, H10D 64/00, H10D 64/27

(54) **SEMICONDUCTOR DEVICE AND METHOD OF MANUFACTURING SUCH SEMICONDUCTOR DEVICE**

(30) Priority: 27.09.2024 NL 2038734
(71) Applicant: Nexperia B.V., 6534 AB Nijmegen (NL)
(72) Inventor: Efthymiou, Epameinondas, Manchester (GB); Cousins, Ian, Manchester (GB); Torgovnikov, Rostislav, Manchester (GB); Kim, Hungjin, Shanghai (CN)
(74) Representative: Pjanovic, Ilija

(57) **Abstract**

The present invention disclosures a semiconductor device preferably a MOSFET transistor, having a EPI layer which is made of semiconductor material such as silicon. The EPI layer has a top surface and a bottom surface opposite to the front surface. The proposed MOSFET is a trench type transistor with the source-polysilicon element embedded in the trench formed in the substate

## Description

### TECHNICAL FIELD

Present disclosure relates, in general, to electronics and, more particularly, to semiconductor device structures such as field effect transistors in particular MOSFET and a method of manufacturing such semiconductor device.

### BACKGROUND OF THE DISCLOSURE

Document US2014008722A1 discloses a vertical-gate transistor disposed on a die which includes a first substrate portion of a first conductivity and a second substrate portion of a second conductivity. The die includes front and rear surfaces, with the first substrate portion extending from the front surface and the second substrate portion extending from the rear surface to the first substrate portion, as well as at least one drain region of the second conductivity extending from the rear surface, and at least one cell. Each cell includes a source region of the second conductivity extending from the front surface, a conductive gate region extending from the front surface to a gate depth, a conductive field-plate region extending from the front surface to a field depth, a gate-insulating layer that insulates the gate region, and a plate-insulating layer that insulates the field-plate region. An intermediate insulating layer insulates the gate region from the field-plate region.

Document US2022216336A1 discloses a semiconductor device includes a region of semiconductor material comprising a major surface and a first conductivity type and a shielded-gate trench structure. The shielded-gate trench structure includes an active trench, an insulated shield electrode in the lower portion of the active trench; an insulated gate electrode adjacent to the gate dielectric in an upper portion of the active trench; and an inter-pad dielectric (IPD) interposed between the gate electrode and the shield electrode. An interlayer dielectric (ILD) structure is over the major surface. A conductive region is within the active trench and extends through the ILD structure, the gate electrode, and the IPD, and is electrically connected to the shield electrode. The conductive region is electrically isolated from the gate electrode by a dielectric spacer. The gate electrode comprises a shape that surrounds the conductive region in a top view so that the gate electrode is uninterrupted by the conductive region and the dielectric spacer.

Document US10825909B2 discloses a method of manufacturing a semiconductor device in the following order: a semiconductor base body preparing step; a first trench forming step; a first insulation film forming step; a gate insulation film forming step; a gate electrode forming step; a second trench forming step of forming a second trench in the inside of a first trench by removing a center portion of the first insulation film; a second insulation film forming step of forming a second insulation film in the inside of the second trench under a condition that a first gap remain in the inside of the second trench; a shield electrode forming step of forming a shield electrode in the inside of the first gap; a shield electrode etching back step of forming a second gap; and a source electrode forming step of forming a source electrode.

Document US8558308B1 discloses a semiconductor die, source zones of a first conductivity type and body zones of a second conductivity type are formed. Both the source and the body zones adjoin a first surface of the semiconductor die in first sections. An impurity source is provided in contact with the first sections of the first surface. The impurity source is tempered so that atoms of a metallic recombination element diffuse out from the impurity source into the semiconductor die. Then impurities of the second conductivity type are introduced into the semiconductor die to form body contact zones between two neighboring source zones, respectively. The atoms of the metallic recombination element reduce the reverse recovery charge in the semiconductor die. Providing the body contact zones after tempering the platinum source provides uniform and reliable body contacts.

Document US8013391B2 discloses a semiconductor power device includes a drift region of a first conductivity type, a well region extending above the drift region and having a second conductivity type opposite the first conductivity type, active trenches extending through the well region and into the drift region where the active trenches define an active area. Inside each of the active trenches is formed a first conductive gate electrode disposed along and insulated from a first trench sidewall, a second conductive gate electrode disposed along and insulated from a second trench sidewall, and a conductive shield electrode disposed between the first and second conductive gate electrodes, wherein the shield electrode is insulated from and extends deeper inside the trench than the first and second conductive gate electrodes. The device also includes source regions having the first conductivity type formed inside the well region and adjacent the active trenches. Electrical contact to the conductive shield electrode can be made inside the active area. The device can also include a perimeter trench extending at least partially around the active trenches such that at least some of the active trenches are perpendicular to the perimeter trench, gate fingers extending from a perimeter gate poly runner located in said perimeter trench, and shield poly fingers extending from a perimeter shield poly runner located in the perimeter trench. The gate fingers are staggered with respect to the shield poly fingers.

Accordingly, it is a goal of the present disclosure to provide an improved the semiconductor transistor structure suitable for high voltage usage which is easier to manufacture.

### SUMMARY OF THE DISCLOSURE

According to a first example of the disclosure a semiconductor device is proposed, preferably MOSFET transistor, having a EPI layer which is made of semiconductor material such as silicon. The EPI layer has a top surface and a bottom surface opposite to the front surface. The proposed MOSFET is a trench type transistor with the source-polysilicon element embedded in the trench formed in the EPI. Accordingly the EPI layer has at least one trench extending from the top surface to the bottom but not fully. The depth of the trench is smaller than the EPI layer thickness. The source-polysilicon is electrically isolated from the EPI layer with the oxide layer. The source-polysilicon have a top part and bottom part wherein the top part is located on the top surface of the EPI layer.

As mentioned before the source-polysilicon is located in the trench and the semiconductor device further comprises gates electrically isolated from the EPI layer (MESA) with the gate oxide layer. The gates are electrically isolated from the source-polysilicon. The gates are located on the top surface side of the EPI layer and the gates extend towards the bottom EPI surface, the gates have a first gate region partially located in the EPI layer region and a second gate region partially located in the liner oxide region. The gates are electrically isolated from the EPI layer substrate and electrically isolated from EPI layer (MESA) with the gate oxide region and electrically isolated from the source-polysilicon with the liner oxide region.

Preferably the gates are formed so that the first gate region extends towards the bottom EPI surface further than the second gate region forming an L-shape like cross section region.

Preferably the first gate region extends towards the bottom EPI surface at least twice the thickness of the second gate region.

Preferably the first gate region thickness is in range of from 700 to 1500 nm.

The disclosure also relates to a method of manufacturing a semiconductor device, the method comprises the steps of:
a. Providing a semiconductor element having a EPI layer with top EPI surface and bottom EPI surface ;
b. First etching mask deposition on the top EPI surface of the EPI layer , wherein the mask has openings for trench etching;
c. Etching trenches extending from the top EPI surface of the EPI layer towards the bottom EPI surface leaving some part of the bottom EPI surface not etched forming non-through trenches ;
d. Depositing an electrical isolation layer at least into the trenches ;
e. Depositing source-polysilicon material into the trenches on the isolation layer filing the trenches ;
f. Depositing a second etching mask on top EPI layer of the EPI layer having at least one opening partially located over the isolation layer at the edge of the trench and partially located over the EPI layer at the edge of the trench ;
g. First etching step configured for etching electrical isolation layer, from the top EPI surface toward the bottom EPI surface forming cavity for the second gate region ;
h. Second etching step configured for etching silicon EPI layer from the top EPI surface toward the bottom EPI surface forming cavity for the first gate region;
i. Depositing a gate oxide insulation layer at least on the first gate region cavity;
j. Filing the first gate region cavity and the second gate region cavity with the semiconductor material forming the gate .

Preferably the EPI layer is made of semiconductor element in particular low doped N type silicon.

Preferably the isolation layer is made of silicon oxide material.

Preferably the source-polysilicon is made of polysilicon material.

Preferably the first etching step is a dry etch process with Ar and Fluorocarbon gas mixture,

Preferably the second etching step is a dry etch process with SF₆/O₂ based etch.

### BRIEF DESCRIPTION OF THE DRAWINGS

The disclosure will now be discussed with reference to the drawings, in which:
Figure 1 shows a cross section of the semiconductor device without top layer metallization.
Figure 2 shows a cross section of the semiconductor device with top layer metallization connected to the source elements and encapsulation layer.
Figure 3 shows a cross section of the semiconductor device with top layer metallization connected to the gate elements and encapsulation layer.
Figure 4 shows a cross section of the substrate element with second etching mask on top part of the silicon EPI layer.
Figure 5 shows a cross section of the EPI with the formed trenches and the L-shape gate cavities.

### DETAILED DESCRIPTION OF THE DISCLOSURE

For a proper understanding of the disclosure, in the detailed description below corresponding elements or parts of the disclosure will be denoted with identical reference numerals in the drawings.

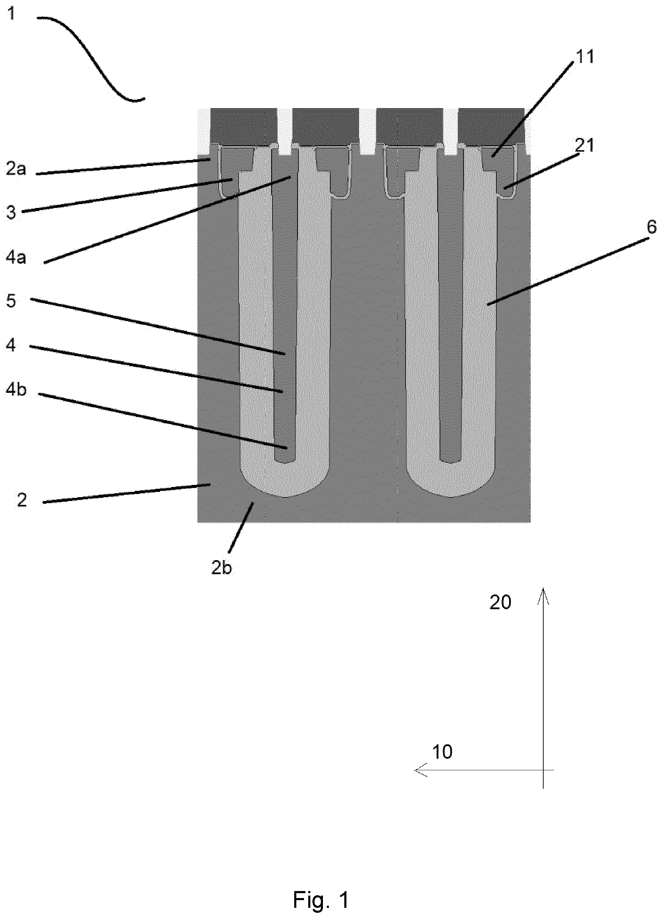

In the first example of the invention, as shown in Figure 1, a semiconductor device configure as a MOS transistor 1 having a EPI layer 2 made of semiconductor material such as relatively low doped N type silicon. It is the layer where the structure of MOSFET is defined. Usually in the range of 2-10um, depending on voltage rating (VDS). In this example for 150V VDS operation device it is 10um . EPI layer have a top surface 2a and a bottom surface 2b opposite to the front surface. The EPI layers has a plurality of trenches 5 extending from the top surface 2 towards the bottom part in the second longitudinal direction (vertically) but not entirely leaving some part of the bottom part 2b not etched. Such trenches are "dead end" trenches not all the way through the EPI. The source-polysilicon 4 is electrically isolated from the EPI layer 2 by oxide layer 6 (thermal oxide layer and /or SAVCD deposited oxide)-.The total trench liner sidewall thickness,( layer 6) is 0.92um). The source-polysilicon 4 have a top part 4a and bottom part 4b wherein the top part 4a is located on the top EPI surface 2a of the EPI layer 2. The source-polysilicon 4 is located in the trench 5 and comprise gates 3 each, gates are electrically isolated from the top EPI region between trenches (also referred as MESA) by oxide layer (thermal oxide layer). The gates 3 are electrically isolated from the source-polysilicon 4 by thermal oxide layer and/or SAVCD deposited oxide layer 6, having a top part of the source-polysilicon 4a located between the gates 3.

The gates 3 are located on the top EPI surface 2a side of the EPI layer 2 and are formed as L-shaped cross section element having, the first longitudinal direction 10 a horizontal protrusion 11 in the second longitudinal direction 20 forming a vertical protrusion 21 (first gate region 21). The gate 3 cross section is upside-down letter L-like element. The horizontal protrusion 11 (second gate region 11) is located on the top surface of the EPI layer 2 and the vertical protrusion 21 is located on the top surface of the substrate 2 and extends in the second longitudinal direction 20 in the direction of the bottom EPI surface 2b.

The L-shaped gate 3 is located partially in the oxide insulating layer 6 and partially in the EPI 2. The gate 3 first gate region 21 extends at least twice the depth of the second gate region 11, the depth of the horizontal protrusion 21 (first gate region 21) is in range of from 700 to 1500 nm.

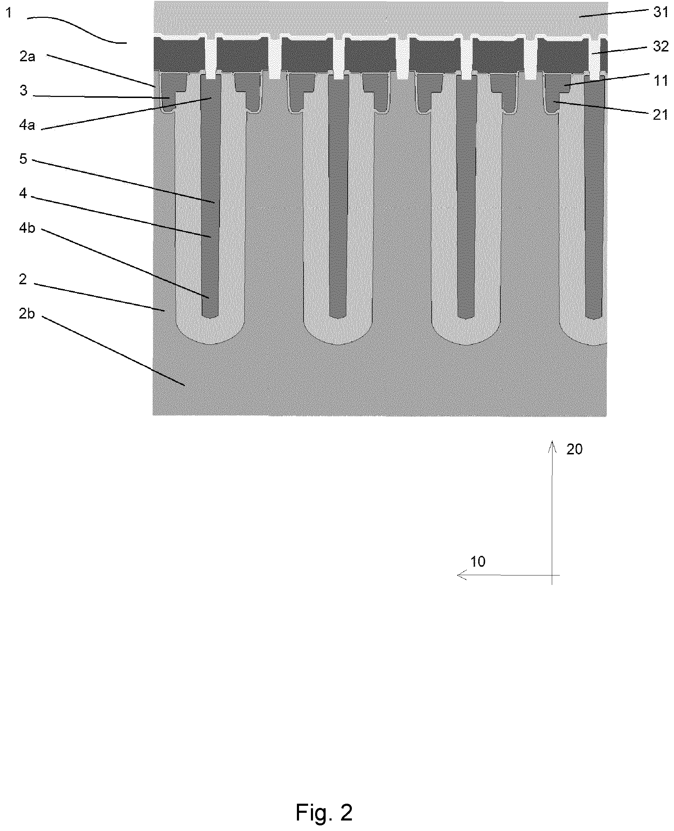

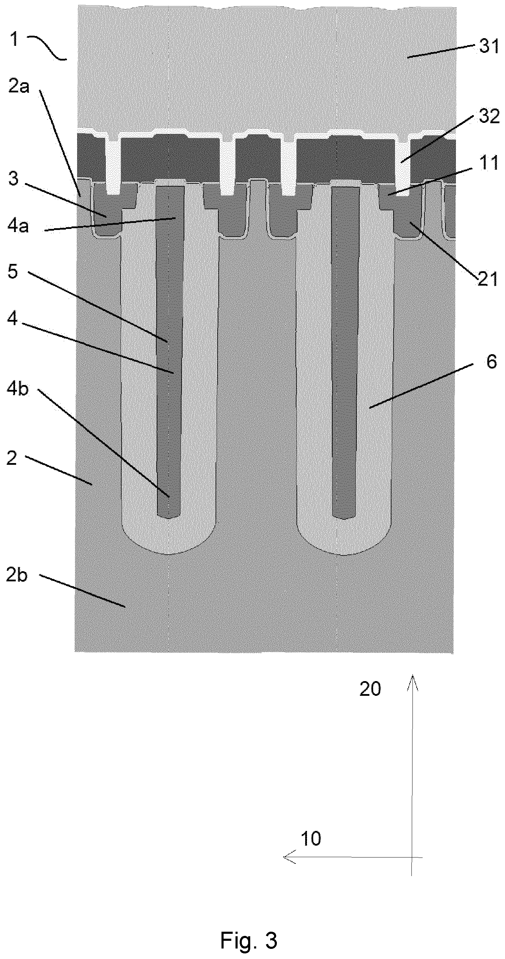

Figure 2 and Figure 3 shows a cross section view of the semiconductor device 1 with metallization forming gate and source contacts.

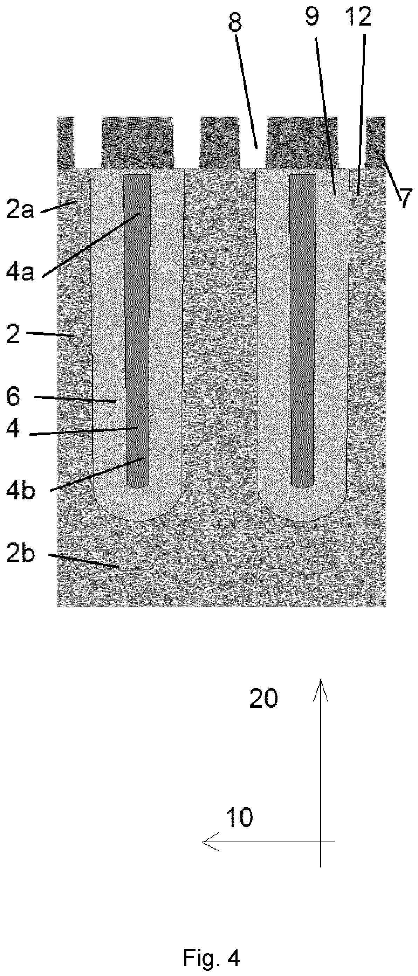

Another aspect of the disclosure is a method of manufacturing semiconductor device. Example of the method of manufacturing a semiconductor device comprising steps:
a. Providing a semiconductor element having a EPI layer 2 with a top EPI surface 2a and a bottom EPI surface 2b;
b. First etching mask deposition on the top EPI surface 2a of the EPI layer 2, wherein the mask has openings for trench 5 etching;
c. Etching trenches 5 extending from the top EPI surface 2a of the EPI layer 2 towards the bottom EPI surface 2b leaving some part of the bottom EPI surface 2b not etched forming non-through trenches 5;
d. Depositing electrical isolation layer 6 at least into the trenches 5;
e. Depositing source-polysilicon 4 material into the trenches 5 on the isolation layer 6 filing the trenches 5 ;
f. Depositing a second etching mask 7 on top EPI layer 2a of the EPI layer 2 having at least one opening 8 partially located over the isolation layer 6 at the edge of the trench 5 and partially located over the EPI layer 2 at the edge of the trench 5. An illustration of the second etching mask is shown in Figure 4;
g. First etching step configured for etching electrical isolation layer 6 from the top EPI surface 2a toward the bottom EPI surface 2b over the first etching target 9 forming cavity for the second gate region 11 ;
h. Second etching step configured for etching EPI layer 2 from the top EPI surface 2a toward the bottom EPI surface 2b over the second etching target 12 forming cavity for the first gate region 21 ;
i. Depositing a gate oxide insulation layer at least on the first gate region 21 cavity;
j. Filing the first gate region 21 cavity and the second gate region 11 cavity with the semiconductor material forming the gate 3 .

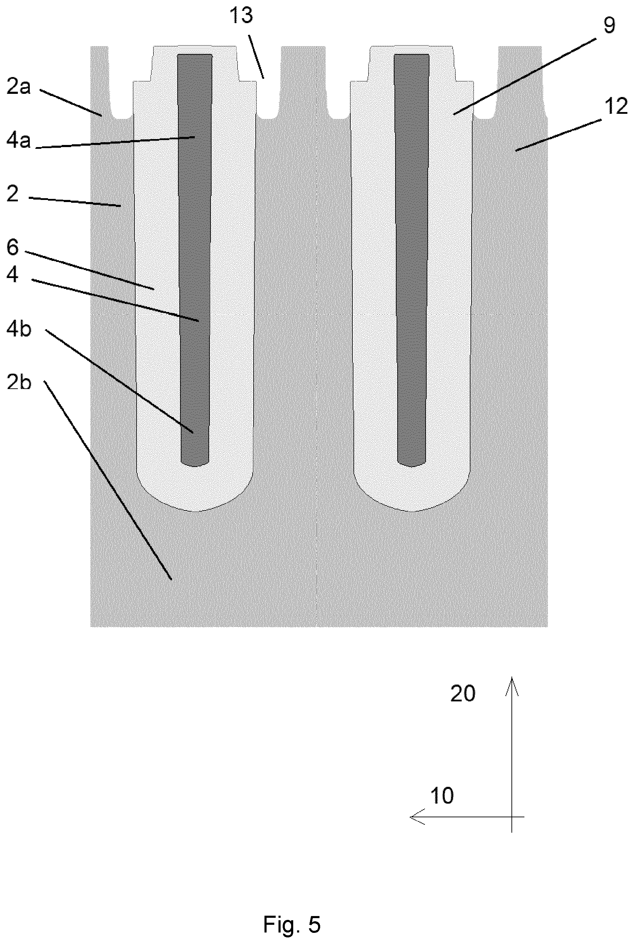

Figure 5 illustrates the gate cavity 13 formed in the first gate region 21 configured to form the gate 3. According to an embodiment, the gate cavity 13 is L-shaped in order to form the gates 3 to said L-shape.

In another example of the disclosure the EPI layer 2 is made of semiconductor element in particular low doped N type silicon.

In another example the isolation layer 6 is made of silicon oxide material and the source-polysilicon 4 is made of polysilicon material. The first etching step is a dry etch process with Ar and Fluorocarbon gas mixture and the second etching step is a dry etch process with SF₆/O₂ based etch.

### LIST OF REFERENCE NUMERALS USED

- 1: semiconductor device
- 2: EPI layer
- 2a: top EPI surface
- 2b: bottom EPI surface
- 3: gate
- 4: source-polysilicon
- 4a: top part of the source polysilicon
- 4b: bottom part of the source polysilicon
- 5: trench
- 6: trench liner oxide-electrical isolation
- 7: mask
- 8: mask opening
- 9: first etching target
- 10: first longitudinal direction (horizontal)
- 11: horizontal protrusion / second gate region
- 12: second etching target
- 13: cavity
- 21: vertical protrusion / first gate region
- 20: second longitudinal direction (vertical)
- 31: first source metal layer
- 32: second barrier metal layer

## Claims

1. A semiconductor device configured as a MOS transistor (1) made of semiconductor material, having an EPI (2) layer with a top EPI surface (2a) and a bottom EPI surface (2b) opposite to the top EPI surface (2a) wherein the EPI (2) has at least one trench (5) extending from the top EPI surface (2a) towards the bottom EPI surface (2b), and at least one source-polysilicon (4) region located in the trench (5) and electrically isolated from the EPI (2) with electrical isolation layer (6) wherein the source-polysilicon (4) has a top part (4a) and a bottom part (4b) wherein the top part (4a) is located on the top EPI surface (2a) of the EPI layer (2), wherein the source-polysilicon (4) further comprise gates (3) having a first gate region (21) partially located in the EPI (2) layer region and a second gate region (11) partially located in electrical isolation layer (6) and wherein the gates (3) extend from the top EPI surface (2a) towards the bottom EPI surface (2b) and wherein the gates (3) are electrically isolated from the EPI (2) layer with the gate oxide layer and electrically isolated from the source-polysilicon (4) with the electrical isolation layer (6).

2. The semiconductor device according to claim 1, wherein the gates (3) are formed so that the first gate region (21) extends towards the bottom EPI surface (2b) further than the second gate region (11) forming an L-shape like cross section region.

3. The semiconductor device according to claim 1, or 2, wherein the first gate region (21) extends towards the bottom EPI surface (2b) at least twice the depth of the second gate region (11).

4. The semiconductor device according to claim 1, 2 or 3, wherein the first gate region (21) depth is in range of from 700 to 1500 nm.

5. The semiconductor device according to claim 1, 2, 3 or 4, wherein electrical isolation layer (6) is at least partially made of thermally grown liner oxide and/or SACVD deposited oxide.

6. A method of manufacturing a semiconductor device according to any of the previous claims from 1 to 5 comprising the steps of:
a. Providing a semiconductor element having a EPI layer (2) with a top EPI surface (2a) and a bottom EPI surface (2b);
b. First etching mask deposition on the top EPI surface (2a) of the EPI layer (2), wherein the mask has opening for trench (5) etching;
c. Etching trenches (5) extending from the top EPI surface (2a) of the EPI layer (2) towards the bottom EPI surface (2b) leaving some part of the bottom EPI surface (2b) not etched forming non-through trenches (5);
d. Depositing electrical isolation layer (6) at least into the trenches (5);
e. Depositing source-polysilicon (4) material into the trenches (5) on the isolation layer (6) filing the trenches (5);
f. Depositing a second etching mask (7) on the top EPI layer (2a) of the EPI layer (2) having at least one opening (8) partially located over the isolation layer (6) at the edge of the trench (5) and partially located over the EPI layer (2) at the edge of the trench (5);
g. First etching step configured for etching electrical isolation layer (6) from the top EPI surface (2a) toward the bottom EPI surface (2b) forming a cavity for the second gate region (11);
h. Second etching step configured for etching the EPI layer (2) from the top EPI surface (2a) towards the bottom EPI surface (2b) forming a cavity for the first gate region (21);
i. Depositing a gate oxide insulation layer at least on the first gate region (21) cavity;
j. Filing the first gate region (21) cavity and the second gate region (11) cavity with the semiconductor material forming the gate (3).

7. The method according to claim 6 wherein the EPI layer (2) is made of semiconductor element in particular low doped N type silicon.

8. The method according to claim 6 or 7 wherein the isolation layer (6) is made of silicon oxide material.

9. The method according to claim 6, 7 or 8 wherein the source-polysilicon (4) is made of polysilicon material.

10. The method according to claim 6, 7, 8 or 9 wherein the first etching step is a dry etch process with Ar and Fluorocarbon gas mixture.

11. The method according to claim 6, 7, 8, 9 or 10 wherein the second etching step is a dry etch process with SF₆/O₂ based etch.
